# EUROPEAN PATENT APPLICATION

(11) **EP 1 772 899 A1**
(43) Date of publication of application: **11.04.2007**
(21) Application number: 06121483.9
(22) Date of filing: 29.09.2006
(51) Int. Cl.: H01L 21/336

(54) **Method for forming a silicide gate**

(30) Priority: 06.10.2005 EP 05447225
(71) Applicant: INTERUNIVERSITAIR MICROELEKTRONICA CENTRUM ( IMEC), 3001 Leuven (BE)
(72) Inventor: Absil, Philippe, B-1471 Loupoigne (BE); Kittl, Jorge Adrian, B-1410 Waterloo (BE)
(74) Representative: pronovem

(57) **Abstract**

The present invention is related to a method for at least partially siliciding an elevated structure having on its top a semiconductor layer, comprising the steps of
- depositing a hardmask (2) over a non-silicided elevated structure (1) having a semiconductor layer on its top,
- providing a sacrificial material coating (4) on top of said hardmask (2),
- etching back said sacrificial material coating (4) until said hardmask (2) over the top of said elevated structure (1) is exposed,
- removing the exposed portion of the hard mask (2),
- removing said sacrificial material (4),
- performing a silicidation of said elevated structure.

## Description

### Field of the invention

The present invention relates to the field of semiconductor process technology and devices. In particular, the present invention relates to a method for forming semiconductor devices with an elevated structure wherein a reaction between a metal and a semiconductor material takes place.

### State of the art

In general, silicidation can be defined as an anneal process resulting in the formation of a metal-semiconductor metal alloy (a silicide) to act as a contact in any semiconductor device, i.e. as a connection between two conductors that permits a flow of current. The process can be applied for any contact located higher than the substrate surface. An example can be a layer stack of some semiconductor material.

A more specific example is found in CMOS (Complementary Metal-Oxide-Silicon) technology. CMOS devices comprise two types of transistors, nMOS and pMOS, each transistor type having its own characteristics and properties. There is a trend to replace the semiconductor gate with a metal one, as metal gates offer the advantages of reducing the sheet resistance, eliminating the semiconductor gate depletion effect, and controlling the work function independently from the doping of the junction regions. Metal gate are therefore considered as a potential candidate for future CMOS technology nodes.

Metal gates can be formed by a silicidation of the semiconductor gate with a metal. The semiconductor gate may be a poly-silicon gate. The metal may be a refractory metal such as W, noble metals such as Pt, near noble metals such as Ni, transition metals such as Ti, or any combination thereof. The full silicidation of the poly-Si gate is obtained by a thermally enhanced reaction between a deposited metal and the already patterned silicon gate similarly to the process used to form self-aligned contacts in the source and drain (S/D) regions of a planar MOS transistor. During the silicidation process, the gate contact is converted into a gate silicide.

There are two main approaches to realise the (fully or partially) silicided gates. In the first approach, a simultaneous silicidation of the source/drain (S/D) regions and the poly-Si gate is performed trading off the needs for a thin contact in the S/D region imposed by the junctions requirements on the one hand and the silicidation of the full thickness of the poly-Si down to gate dielectric interface on the other hand. The second approach consists of decoupling the silicidation of the S/D regions and the gate by properly protecting the S/D regions during the silicide formation process (i.e. with a material that does not react with the metal). While the simultaneous approach is more economical in terms of number of process steps and minimises the thermal budget after contact formation, the decoupling approach allows the formation of a different silicide material for the gate and the S/D contacts and does not require silicide thickness matching between gate and S/D.

The main approach for decoupling S/D and gate contact consists in protecting the S/D by an oxide that is first deposited, then planarised by chemo-mechanical polishing (CMP) and then etched back to open the top of the poly-Si. Although this approach employs existing processing techniques, chip manufacturers preferably avoid it because of potential yield issues. Besides, this approach leaves a relative thick oxide above the S/D regions, difficult to remove without affecting the device integrity, specifically without damaging the S/D silicide underneath. With the protective oxide present, the efficiency of deposited strained layers, typically used for device performance improvement, is significantly reduced. Another drawback of such approach is the increased risk of protective oxide removal when fully silicided gates are realised combined with elevated S/D transistors because of a process window difference for the etch back step used to open the gate top. This makes the approach partially incompatible with today's state-of-the-art transistors.

Also when considering the making of silicided contacts more in general, it is desirable to avoid the CMP step because of the above-mentioned yield issues.

Patent document US-6657244-B teaches a method for forming a silicided gate structure. Two approaches are proposed. Firstly, after siliciding source, drain and gate, a second silicidation is performed to thicken the gate silicide. In FUSI technology the gate silicide of nMOS and pMOS needs to be made different either by doping the gate by means of implantation, or by using a different metal during silicidation. Therefore this approach is very complex to use since the gate is already partially silicided before the differentiation between nMOS and pMOS can be obtained.
The second approach is the following. After siliciding source, drain and gate, the silicided part of the gate is removed again and a different second silicidation is performed. Besides its complexity, this approach has the disadvantage that the removal of the silicided part of the gate can result in a rough gate top surface or even a varying gate thickness before starting the second silicidation. This can lead to the differences in device performance.

### Aims of the invention

The present invention aims to provide a method for at least partially siliciding an elevated structure provided with a semiconductor layer on its top, wherein a chemo-mechanical polishing step is avoided.

### Summary of the invention

The present invention relates to a method for at least partially siliciding an elevated structure having on its top a semiconductor layer, comprising the steps of
- depositing a hardmask over a non-silicided elevated structure having on its top a semiconductor layer,
- providing a sacrificial material coating on top of the hardmask,
- etching back the sacrificial material coating until the hardmask over the top of the elevated structure is exposed,
- opening the elevated structure,
- removing the sacrificial material,
- performing a silicidation of the elevated structure.

In a preferred embodiment the hardmask can be any material that is suitable to be deposited and dry-etched selectively towards the elevated structure. More particular it can be silicon oxide, silicon nitride or silicon carbide.

Preferably the sacrificial material coating can be any self-planarising coating suitable to be spun on the hardmask and etched back afterwards. More particularly it can be BARC (bottom anti-reflective coating) or photo-resist.

Advantageously a plurality of at least partially silicided elevated structures can be formed. The step of etching back the sacrificial material coating can be performed until the lowest top of the plurality of elevated structures is exposed.

In a specifically advantageous embodiment the hardmask is in SiO₂. The elevated structure advantageously is a poly-Si gate electrode on top of a gate dielectricum. Said gate dielectricum can be typically SiON, SiO or a high-k material. In a preferred embodiment the step of hardmask deposition can be performed after a silicidation of a source and drain. Alternatively a silicidation of a source and drain can be performed after the silicidation of said gate.

In another aspect the invention relates to the use of a method for forming a silicided elevated structure as described, for forming a MOSFET transistor comprising a fully silicided gate.

In yet another aspect the invention relates to the use of a method as previously described, wherein the source and the drain of the MOSFET transistor are in a first silicide material and wherein the fully silicided gate is in a second silicide material, different from the first silicide material.

### Short description of the drawings

Fig. 1 represents the hard mask deposition.

Fig. 2 represents the planarising polymer (PP) coating.

Fig. 3 represents the sacrificial etch back step to expose the tops of the elevated structures.

Fig. 4 represents the opening of the elevated structure.

Fig. 5 represents the sacrificial material removal.

Fig. 6 represents the silicidation metal deposition.

Fig. 7 represents the removal of the rest of the hardmask.

### Detailed description of the invention

In the solution according to the present invention an alternative to the CMP route is proposed. Doing so, any CMP step is avoided and a significant reduction of the protective oxide thickness can be achieved.

The solution according to the invention makes use of a sacrificial protective layer during the opening process that can be removed prior to the silicidation without damaging the underlying layers.

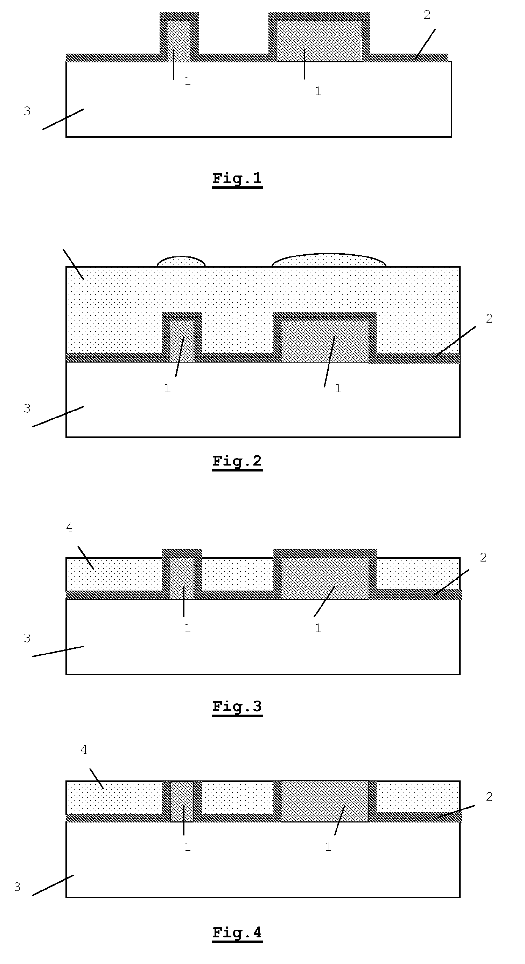

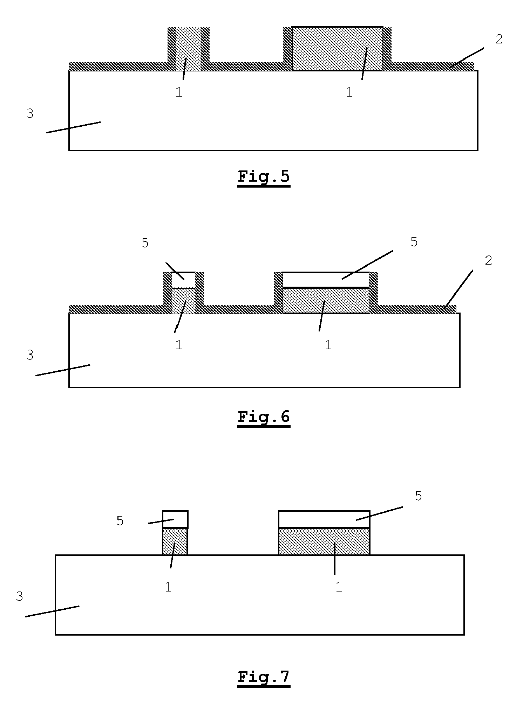

The process sequence is as follows:
(i) a thin hardmask material (2), suitable for silicidation, is deposited over a non-silicided elevated structure (1), said structure having a semiconductor layer in its top and being higher than the substrate (3) surface (Fig.1). Alternatively the elevated structure with the small semiconductor layer on top may be obtained as a result of a shallow trench isolation (STI) step wherein surrounding areas have been lowered. (It is to be noted that in the art STI is often performed in combination with a CMP step, hence the same problems as previously described occur.) The elevated structure is advantageously, but not necessarily a gate stack comprising a gate electrode and a gate dielectricum. Any material that can be deposited and dry etched and does not react with the silicide in question is suitable for silicidation. The hardmask thickness should preferably be about a few tens of nm. Examples comprise SiO₂, SiN, SiC or amorphous carbon layer. In case CMOS technology is used, the hardmask material is advantageously SiO₂. The hardmask is then preferably deposited on the encapsulated (by gate hardmask and spacers) transistors after S/D silicidation. (ii) the devices are spun coated with a sacrificial material (4) (ex.: BARC, photo-resist, ...) that planarises the wafer topography (Fig.2); (iii) the sacrificial material (4) coating is etched back to expose the hardmask (2) only on top the elevated structures (1) (Fig.3); (iv) once the hardmask over the tops of the structures (1) is exposed, a second etchback is performed to remove the hardmask (2) deposited in step (i) selectively towards the sacrificial material (4) coating (Fig.4). In case of gate silicidation, also the gate hardmask is removed selectively, while the S/D regions are protected by the sacrificial material; (v) the sacrificial material (4) coating is removed without damaging the device structure (Fig.5); (vi) the elevated structure (1) with the semiconductor layer on its top is now ready to be at least partially silicided following typical silicidation (Fig.6) flow starting with a metal deposition, then a partial anneal, a selective etch and a final anneal to complete the silicidation. After silicidation is completed, the rest of the hardmask is removed selectively towards the underlying layers and the elevated structure (1) provided with a silicided part (5) (Fig.7). In a specific example with CMOS technology the silicidation of the source and drain is performed after the above-mentioned steps for forming a silicidated gate are carried out. After the silicidation process is completed, the transistors are ready to continue processing through BEOL (back-end-of-line).

It is important to note that prior to BEOL CMOS processing, it is possible to include a hardmask removal step to etch away protective layer present in the S/D regions, provided that this layer is thin enough and can be selectively etched with respect to the silicide formed in the gate and in the S/D.

This process according to the present invention avoids any CMP step and provides a topography very similar to the one obtain for standard poly-Si gates used in today's state-of-the-art CMOS fabrication. Both aspects make FUSI gates easier to integrate.

## Claims

1. Method for at least partially siliciding an elevated structure having on its top a semiconductor layer, comprising the steps of
- depositing a hardmask (2) over a non-silicided elevated structure (1) having on its top a semiconductor layer,
- providing a sacrificial material coating (4) on top of said hardmask (2),
- etching back said sacrificial material coating (4) until said hardmask (2) over the top of said elevated structure (1) is exposed,
- opening said elevated structure (1),
- removing said sacrificial material (4),
- performing a silicidation of said elevated structure.

2. Method for at least partially siliciding as in claim 1, wherein said hardmask (2) is any material suitable to be deposited and dry-etched selectively towards said elevated structure.

3. Method for at least partially siliciding as in any of claims 1 or 2, wherein said sacrificial material coating (4) is any self-planarising coating suitable to be spun on the hardmask (2) and etched back afterwards, more particularly bottom anti-reflective coating or photo-resist.

4. Method for at least partially siliciding as in any of the claims 1 to 3, wherein a plurality of at least partially elevated structures (1) is formed.

5. Method as in claim 4, wherein said step of etching back said sacrificial material coating (4) is performed until the lowest top of said plurality of elevated structures (1) is exposed.

6. Method as in any of the previous claims, wherein said hardmask (2) is in silicon oxide, silicon nitride or silicon carbide.

7. Method as in claim 6, wherein said elevated structure (1) is a poly-Si gate electrode on top of a gate dielectricum.

8. Method as in claim 7, wherein said gate dielectricum is SiON, SiO or a high-k material.

9. Method as in claim 7, wherein the step of hardmask deposition is performed after a silicidation of a source and drain.

10. Method as in claim 7, wherein a silicidation of a source and drain is performed after the silicidation of said gate contact.

11. Use of a method as in any of claims 6 to 10 for forming a MOSFET transistor comprising a fully silicidated gate stack.

12. Use of a method as in claims 9 or 10, wherein the source and the drain of said MOSFET transistor are in a first silicide material and wherein said fully silicided gate is in a second silicide material, different from said first silicide material.
